(19) Europäisches Patentamt

European Patent Office

Office européen des brevets

(11) **EP 1 304 657 A2**

(12) **EUROPEAN PATENT APPLICATION**

(43) Date of publication:
**23.04.2003 Bulletin 2003/17**

(51) Int Cl.[7]: **G06T 17/40**

(21) Application number: **02020449.1**

(22) Date of filing: **11.09.2002**

| | |
|---|---|
| (84) Designated Contracting States:<br>**AT BE BG CH CY CZ DE DK EE ES FI FR GB GR**<br>**IE IT LI LU MC NL PT SE SK TR**<br>Designated Extension States:<br>**AL LT LV MK RO SI** | (72) Inventor: **Kawai, Motomasa,**<br>**Toyota Caelum Incorporated**<br>**Nagoya-shi, Aichi-ken, 460-0008 (JP)** |
| (30) Priority: **11.10.2001 JP 2001313854** | (74) Representative:<br>**Winter, Brandl, Fürniss, Hübner, Röss, Kaiser,**<br>**Polte Partnerschaft** |
| (71) Applicant: **Toyota Caelum Incorporated**<br>**Nagoya-shi, Aichi-ken, 460-0008 (JP)** | **Patent- und Rechtsanwaltskanzlei**<br>**Alois-Steinecker-Strasse 22**<br>**85354 Freising (DE)** |

(54) **Object display system**

(57)    A display system, a display method and a recording media thereof that displays at least one part of the object selected in a detail view (14) and at least one other part unselected, and related to the detail view (14), in an outline view (13) on a display device based on the relational information. The display system comprises a memory (9, 10), an input device (3) and a controller (2). The memory (9, 10) stores drawing data of at least one part of the object. The input device (3) receives input conditions used to display the drawing on a display screen of the display device (4). The controller (2) imports selective information input from the input device (3) to determine the at least one part of the object selected to be displayed in at least one of a detail view (14) and an outline view (13). The controller (2) also imports relational information input using the input device (3) to determine a relation between parts and reads-in the drawing data from the memory (9, 10).

F I G. 1

**Description**

BACKGROUND OF THE INVENTION

1. Field of Invention

This invention generally relates to construction of an object on a display. The present invention pertains to a display system, a display method for rendering a construction view of the object, and a recording media thereof.

2. Description of Related Art

A computer-aided-design (hereinafter, referred to as CAD), which is a design system aided by a computer, is widely available for designing parts (i.e., parts) of an automobile. Designing products using the CAD system has various advantages compared to the conventional paper-based manual product designing in view of the ease of processing and modifying the data, the capability for performing the simulation, and the ease of searching and reusing the previous data.

Often, it may be required to design products with a complex construction including a large number of parts using the CAD system. In this case, designers are required to conduct a display operation of one part (or design object) among a plurality of parts to be processed. This display operation is bothersome and mistakes are made because of inaccurate display operations.

To overcome the foregoing drawbacks, it may be considered to import the CAD data including only the part that is to be processed by the designer for construction based on the data thereof. Although the foregoing drawback is obviated, other drawbacks are generated. That is, the data format is required to be adjusted or converted, when the CAD data format drawn by the designer is different from the CAD data format of the parts, such as where the drawn data is to be attached. In this case, the transaction for adjusting the format is bothersome.

SUMMARY OF THE INVENTION

In light of the foregoing drawbacks, it is an object of the present invention to provide a display system, a display method, and a recording media thereof for displaying a drawing having a selected portion rendered in a detail view.

It is further object of the present invention to provide a display system that constructs a drawing of an object on a display device with an aid of a computer. The display system includes a memory, an input device and a controller. The memory stores drawing data of at least one part of the object. The input device receives input conditions used to display the drawing on a display screen of the display device. The controller imports selective information input from the input device to determine the at least one part of the object selected to be displayed in at least one of a detail view and an outline view. The controller also imports relational information input using the input device to determine a relation between parts and reads-in the drawing data from the memory. The controller then constructs the at least one part of the object selected in at least one of the detail view and the outline view on the display device based on the imported relational information.

According to the display system, the operator determines which portion of the design drawing is to be displayed in the detail view, and in the outline view, using the input device. The selective information is imported by the controller. The operator inputs the relation between the various parts of the object using the input device. The controller imports the relational information. The drawing data is read in from the memory by the controller to construct the at least one part selected in the detail view and to construct the at least one part unselected, and related to the detail view, in the outline view on the display device based on the relating information.

Thus, when the object is designed, the at least one part selected as the object to be displayed in the detail view and the at least one part unselected, and related to the detail view, is displayed in the outline view on the display device. Accordingly, the at least one part which is to be rendered can be easily processed and displayed in the detail view.

According to a further aspect of the invention, it is another object to provide a display method used for a display system that constructs a drawing of an object with an aid of a computer on a display device. The method includes at least the following steps: importing selective information input from an input device when selecting a portion of the object to be displayed in at least one of a detail view and an outline view; importing relational information input using the input device to determine the relation between the parts; reading-in stored drawing data; and constructing at least one part of the object selected in a detail view and constructing at least one part of the object unselected, and related to the detail view, in an outline view on the display device based on the relating information.

According to the foregoing method, an operator can determine which part of the drawing is to be displayed in the detail view or in the outline view in the drawing by using the input device to create selective information that is imported by a controller. The operator can also inputs the relation between each of the parts of the object using the input device. The controller imports the relational information between the parts. The controller reads-in the drawing data from the memory, constructing the part selected in the detail view and constructing the part unselected, and related to the detail view, in the outline view on the display device based on the relational information.

Thus, when designing the object, the at least one part of the object selected by the designer is displayed in the detail view and the at least one part unselected, and related to the detail view, is displayed in the outline view. This mode of designing the object is desirable.

According to a further aspect of the invention, it is another object to provide a recording media which is readable by the computer including a program that executes each step according to above-mentioned method by the computer.

As to the recording media, when designing the object, the at least one part of the object selected by the designer is easily processed and displayed in the detail view and the at least one part unselected, and related to the detail view, is easily processed and displayed in the outline view according to the needs of the designer.

According to a further aspect of the invention, it is preferable that the relational information includes assembly condition data that shows an assembly condition between parts of the object, and that the controller constructs the at least one part of the object selected in the detail view, in the outline view on the display device based on the assembly condition data.

With this construction, the relation between the part displayed as the detail view and the part displayed as the outline view is determined by the assembly condition data showing the assembly condition between the parts.

According to a further aspect of the invention, it is preferable that the relational information includes assembly structure data that shows an assembling relation of at least one part of the object by sub-portions of the parts to show the assembling condition between the at least one part, and that the controller constructs the object determined by the at least one part selected in the detail view and the at least one part unselected, and related to the detail view, in the outline view on the display device based on the assembly structure data.

With this construction, the relation between the part displayed as the detail view and the part displayed as the outline view is determined by the assembly structure data showing the assembly condition between parts and showing the assembling relation of the construction view object hierarchically by the part.

According to a further aspect of the invention, the relational information includes temporary structure data that determines an existence of a relation between the parts. The controller constructs the at least one part selected in the detail view and constructs the at least one part unselected, and unrelated to the detail view, in the outline view based on the temporary structure data, and omits at least one part unselected and unrelated to the detail view from being displayed on the display device based on the temporary structure data.

According to the present invention, the display of the display device of the part which is unrelated to the detail view determined by the temporary structure data among a plurality of the parts constructing the construction view object. Thus, by isolating the parts which are unrelated to the designing among the plurality of parts constructing the construction view object, the unrelated parts are not displayed on the display device and thus the obstacles for constructing the part to be designed is erased.

According to a further aspect of the invention, the controller constructs the at least one part selected in the detail view. Furthermore, the controller constructs the at least one part unselected, and related to the detail view, in the outline view on the display device based on the relational information. Each part of the object is made up of numerous portions parsed into various levles and the controller constructs the drawing of the object, level by level, based on assembling relation data.

With this construction, the transaction for displaying the part selected in the detail view and the part unselected in the outline view is performed level by level. Thus, the designing object of the construction view object can be displayed as the detail view level by level from the rough level, which makes it easy to check and confirm the design drawing.

According to a further aspect of the invention, the controller constructs the outline view of the object by reducing unnecessary lines in an outer shape of at least a first part that is matingly assembled to a second part when constructing the ouline view.

With this construction, unnecessary visible outline is not displayed and thus the simplified outline view without unnecessary lines can be displayed.

BRIEF DESCRIPTION OF THE DRAWINGS

The above mentioned and other objects, features, advantages, technical and industrial significance of this invention will be better understood by reading the following detailed description of exemplary embodiments of the invention, when considered in connection with the accompanying drawings, in which:

Fig. 1 shows a construction of a construction view display device according to an exemplary embodiment of the present invention;
Fig. 2 is a CAD drawing of a product displayed on a display according to an exemplary embodiment of the present invention;
Fig. 3 is an input screen view of assembling relation data according to an exemplary embodiment of the present invention;
Fig. 4 is an input screen view of assembly condition data according to an exemplary embodiment of the present invention;
Fig. 5 is an explanatory view regarding the assembly condition data according to an exemplary embodiment of the present invention;
Fig. 6 is illustrated data for a CAD data displayed as a simplified view according to an exemplary embodiment of the present invention;

Fig. 7 is an explanatory view regarding a display transaction when displaying an outline view according to an exemplary embodiment of the present invention;

Fig. 8 is an input screen drawing for a temporary structure data according to an exemplary embodiment of the present invention;

Fig. 9 is a CAD data displayed as a simplified view according to an exemplary embodiment of the present invention; and

Fig. 10 is a flowchart carried out when performing a display transaction of the simplified view according to an exemplary embodiment of the present invention.

## DETAILED DESCRIPTION OF EXEMPLARY EMBODIMENTS

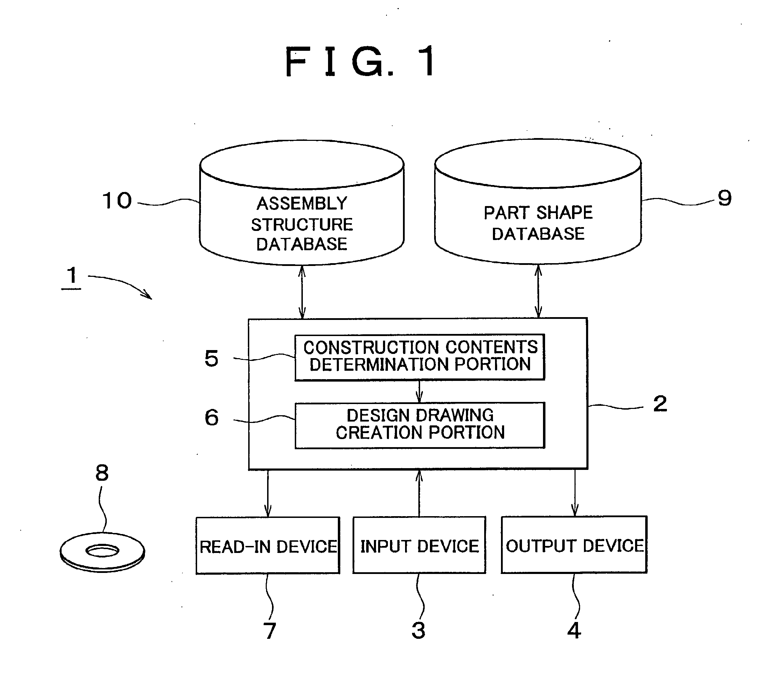

In accordance with exemplary embodiments of the present invention, a construction view display system, a construction view display method, and a recording media thereof will be explained referring to Figs. 1-10.

Fig. 1 shows a construction view display device 1 for creating a design drawing of a product. The drawing is a construction view object rendered by a CAD system. The construction view display device 1 includes a control device 2 (or controller), an input device 3 serving as an input, and an output device 4 serving as a display device. The control device 2 creates the drawing that relates to the product based on the information and the drawing information input by the input device 3. The drawing is output from the output device 4 in and appropriate form. The control device 2 includes a CPU, A ROM, and RAM. The input device 3 includes a keyboard and a pointing device. The output device 4 includes a display and a printer.

As shown in Fig. 1, the control device 2 includes a construction contents determination portion 5 serving as a display condition determination device and a relating condition determination device. A design drawing creation portion 6 serves as a construction device. The construction contents determination portion 5 is for selecting which portion of a product to be a construction view object is to be displayed as a detail view by a user for determining the selected portion as a condition when displaying the drawing. Based on the determination condition determined by the construction contents determination portion 5, the design drawing creation portion 6 constructs the selected portion (selected by the user) as the detail view, constructs the unselected portion related to the detail view as an outline view, and displays a design drawing thereof on the output device 4.

The construction view display device 1 includes a read-in device 7 to which a CD-ROM 8 serving as a recording media is set. The read-in device 7 reads in a drawing display program as a program written in the CD-ROM 8 for installing the program in a hard disc (not shown). The control device 2 constructs the portion selected by the user as the detail view and the other unselected portions as the outline view based on the drawing display program for displaying a design drawing thereof on the output device 4.

The construction view display device 1 includes a part shape database 9 serving as a storage device in which various data input by the input device 3 is stored, and an assembly structure database 10. The part shape database 9 stores the shape data (i.e., three-dimensional data) of a part which is a minimum disassembling unit of a product. The assembly structure database 10 stores the assembly structure data for determining the relation of the assembly between each part. The assembly structure data determines which predetermined part is assembled to which position of which part. The shape data and the assembly construction data serve as the drawing data, and the assembly structure data serves as the relating information.

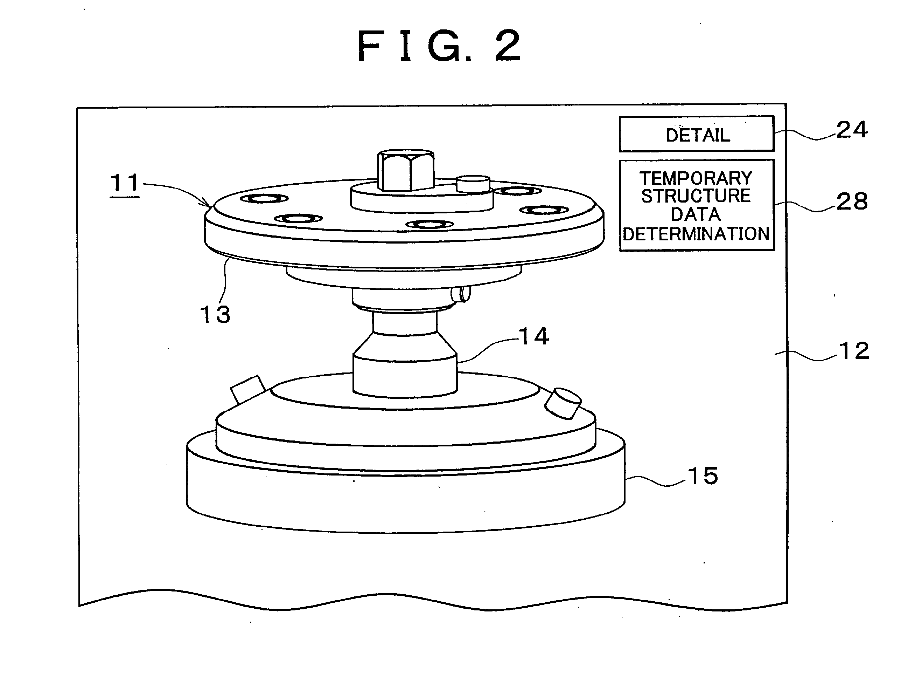

Fig. 2 shows a CAD drawing of the product displayed on the display of the output device 4. A CAD drawing 12 of a product 11 includes a three-dimensional CAD data display as a detail view with shadow under normal rendering conditions. The CAD drawing 12 is drawn by assembling a predetermined part input by the user as an element of the product 11 in a predetermined order and to a predetermined position. The viewing direction of the CAD drawing 12 of the product 11 can be freely determined.

The product 11 is parted, or partitioned, level by level in accordance with a parting unit by a unit which is a constructional unit. For example, the product 11 is parted into units 13-15. The units 13-15 are parted in accordance with the parting unit. The units of the lower level are sequentially parted in accordance with the parting unit, which is the minimum constructional unit of the product 11.

The procedure for creating the CAD drawing of the product 11 shown in Fig. 2 will be explained as follows. The shape data of the part relating to the product 11 is drawn as the drawing that is to be designed. Simultaneous with the creation of the shape data, the assembly structure data (i.e., assembly relating data and assembly condition data) regarding the part is input. The shape data of the part is created by either using the CAD data downloaded from an outside source, or by data from the user using the input device 3.

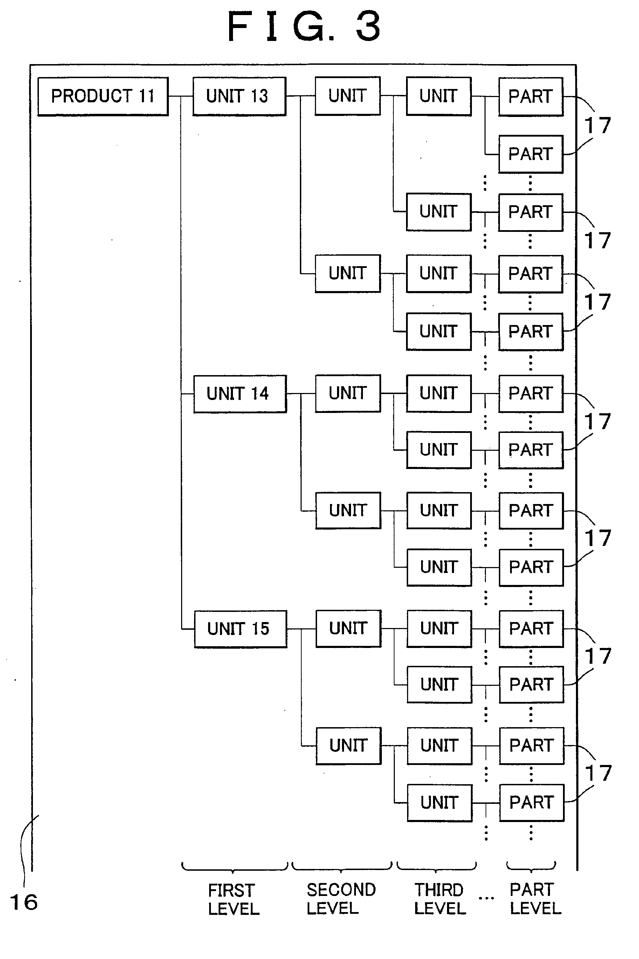

On the other hand, data input from the assembly structure database is performed as follows. According to this embodiment, an input screen 16, as shown in Fig. 3, is displayed on the display of the output device 4 for inputting the assembling relation data with a tree structure. The assembling relation data is the data that determines what units are to be assembled to construct the product 11. The product 11 is a parted object that together forms the product. According to this embodiment, the product 11 constructs three units 13-15 in the first level. The units 13-15 are shown constructed with predetermined units in a second level. The units of the following lower levels together combine to make up the construction of the first level. The units of the product 11 are further parted into smaller parts as the levels go lower.

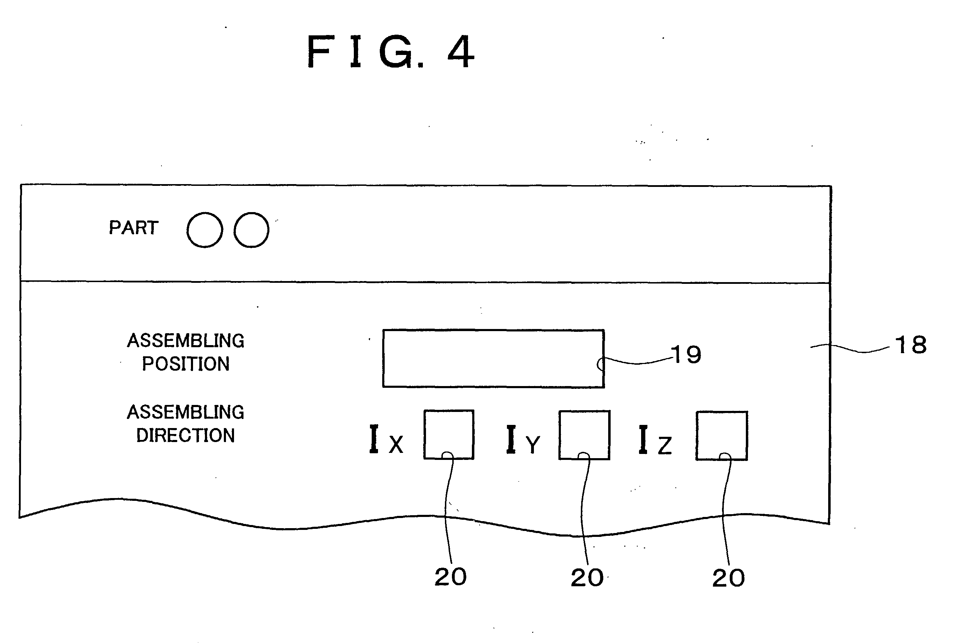

On the input screen 16, a portion displayed as "part" can be selected by a mouse. When a button 17 of the part is clicked, an input screen 18, as shown in Fig. 4, is displayed on the display. The input screen 18 is provided with an input column 19 for the assembling position (i.e., reference position) and an input column 20 for the assembling direction (i.e., three-dimensional direction). By inputting the conditions in the input columns 19, 20, the assembly condition data is input. The assembly condition data is the data for determining the assembling position and the assembling direction between parts. The shape data is stored in the part shape database 9 and the assembly structure data is stored in the assembly structure database 10.

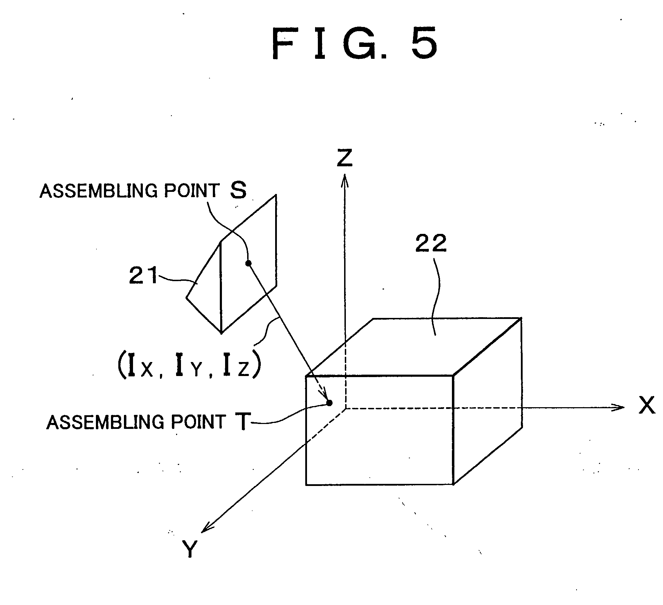

Fig. 5 illustrates the input of the assembly condition data. To specify which position of a first part to be the input object (i.e., first part 21 of Fig. 5) is assembled to which position of a second part to be assembled (i.e., a second part 22 of Fig. 5), an assembling point S of the first part 21 and an assembling position T of the second part 22 are input in the input column 19. To specify the assembling direction of the first part 21 relative to the second part 22, the assembling direction of the first part 21 (Ix, Iy, Iz), that is, the angle of the first part 21 relative to the X, Y, Z axis as the assembling direction to the second part 22 are input in the input column 20 respectively. Thus, the first part 21 and the second part 22 are assembled by moving the first part 21 following the assembling direction making reference to the second part 22 for connecting the assembling point S to the assembling point T.

The CAD drawing 12 on which the unit (i.e., part) is assembled in is constructed by assembling the parts following the conditions determined by the assembly structure data. That is, the control device 2 assembles the part which is at the lowest level in the assembling relation data following the assembly condition data first. Then, the units are consecutively assembled from the lower level of the parting levels for constructing the CAD drawing 12 which illustrates a rendering of the units assembled.

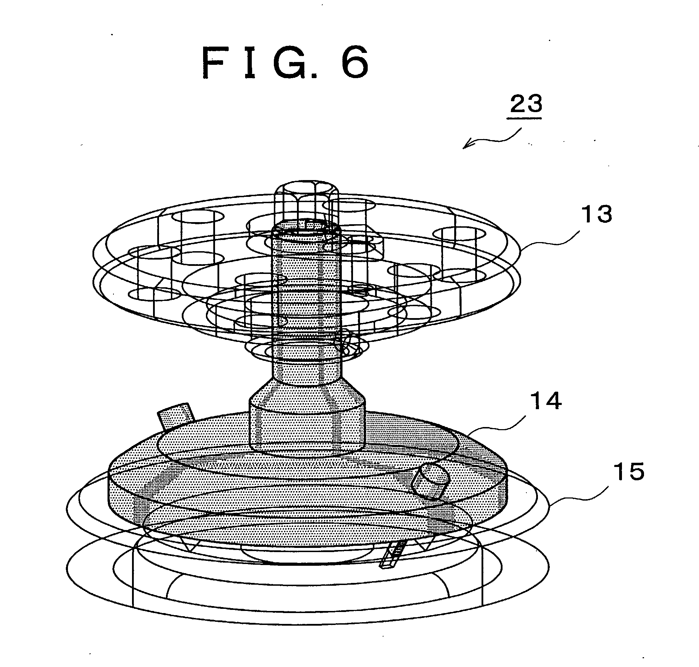

Fig. 6 shows a CAD drawing showing a portion of the product 11 in detail view and other portions in outline view. When designing the product 11, construction of the product 11 may be rendered of one part or the assembly of parts as a unit. According to a function of the CAD drawing, one function is to display only the unit specified by the designer (i.e., user) of the entire view of the product 11 in the detail view, and to display the unspecified remainder of the unit related to the detail view in the outline view, as shown in Fig 6.

That is, when designing the product 11, the unit to be designed is specified on the display by the designer using the input device 3, such as mouse. The specified unit is displayed in the detail view and the remaining unspecified units are displayed as a simplified view 23 shown in the outline view. In this case, the detail view corresponds to a drawing showing the object to be displayed in solid shadowing and in an outline view. According to this embodiment, the unit 14 is specified as the object to be displayed in detail in the solid shadowing. Thus, the unit 14 is displayed in detail and units 13, 15 are shown in the outline.

The procedure for displaying the simplified view 23 of the product 11 shown in Fig. 6 will be explained as follows. When the entire product 11 is selected to be displayed, the CAD drawing 12 is determined and displayed on the display device 4. The designer can select an object, or portion of the entire product 11, to be rendered in the detail view and the other unselected portions in the outline view selection is made level by level from the higher level by the parting unit of the unit constructing the product 11.

As shown in Fig. 2, a detail button 24 can be selected, e.g., by clicking the mouse, is provided on the display device 4. On the CAD drawing 12 in which the entire portion of the product 11 is displayed, the designer selects the unit to be displayed as the detail view with mouse then clicks the detail button 24. In this embodiment, the unit 14 is clicked to be selected and the detail button 24 is clicked.

In this case, the construction contents determination portion 5 determines the detail view for the unit selected by the designer and the outline view for the unselected neighboring units adjacent to the selected detail view. The design drawing creation portion 6 displays the unit specified in detail view and the other unselected units in outline views on the display device. The detail and outline views are generated in response to the shape data and the assembly structure data based on the determined condition of the construction contents determination portion 5. Accordingly, as shown in Fig. 6, the unit 14 is displayed in detail, and the units 13, 15 are displayed in outline.

For displaying the detail of units located at the lower level of the unit 14, the detail button 24 is selected after clicking a desired unit to display. In this case, only the clicked unit is displayed in detail and the other unselected units are displayed in outline. By performing the display transaction level by level by the parting unit of the unit constructing the product 11, only the selected unit to be designed (or generated) by the designer is displayed in detail. Thus, the transaction for displaying a unit in the detail view can be performed easily when designing the product 11.

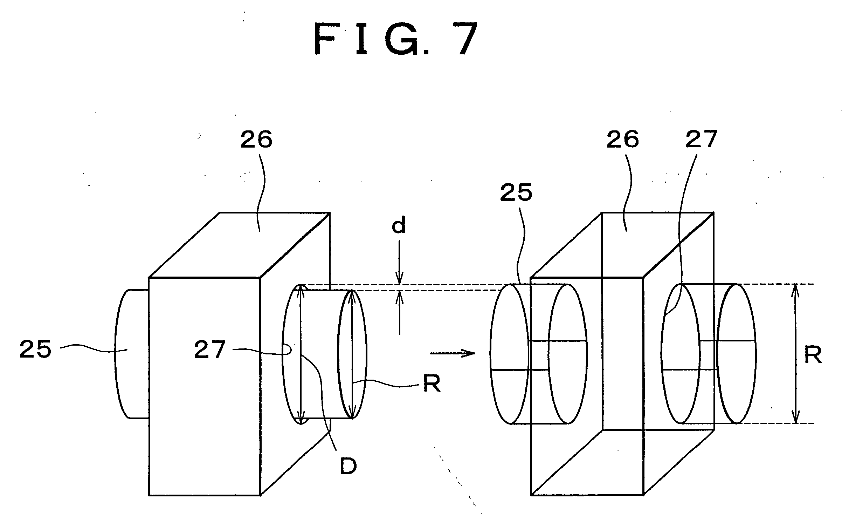

The design drawing creation portion 6 performs a special display transaction, or procedure, to display the visible outline. An example of the transaction is explained referring to Fig. 7. A view positioned on the left side of Fig. 7 is an actual product shape constructed as a design drawing, which in this case, is displayed on the display as the detail view. A view positioned on the right side of Fig. 7 is an outline shape displayed on the display in the outline view. A cylindrical part 25 is inserted into a bore 27 of a block part 26 for assembling the cylindrical part 25 and the block part 26.

When designing the drawing in which the cylindrical part 25 is inserted into the bore 27, clearance is provided between an external periphery of the cylindrical part 25 and an internal periphery of the bore 27 according to a predetermined measurement for designing, so that the cylindrical part 25 can be inserted into the bore 27. Thus, the cylindrical part 25 and the block part 26 are displayed in detail view. The design drawing creation portion 6 calculates a diameter R of the cylindrical part 25 according to equation (1).

$$R = D - 2d \pm \text{tolerance} \qquad (1)$$

D corresponds to the diameter of the bore 27 of the block part 26. The tolerance can be defined as the difference between the maximum value and the minimum value acceptable for machining. The design drawing creation portion 6 creates the detail view of the product 11 based on the equation (1) as a drawing having a solid shadowing based on the measurement for designing the display as the detail view.

On the other hand, to display the cylindrical part 25 and the block part 26 as an outline view, the design drawing creation portion 6 calculates the diameter R of the cylindrical part 25 according to equation (2).

$$R = D \pm \text{tolerance} \qquad (2)$$

Thus, the design drawing creation portion 6 constructs the cylindrical part 25 being inserted into the bore 27 by simplifying the detail view based on the equation (2) when displaying the product 11 on the display in the outline view. Thus, when displaying the outline portion of the product 11 (as shown in Fig. 7), the visible outline showing the external periphery of the cylindrical part 25 and the visible outline showing the internal periphery of the block part 26 and the bore 27 are not shown in the outline view, thus avoiding unnecessary lines.

As shown in Fig. 2, a temporary structure data determination button 28 is provided on the display for designing the product 11 and is operable by selecting with the mouse. When designing the product 11, the mating connection between each of the units is considered. The temporary structure data determination button 28 is operable for relating to, and isolating, the mating units.

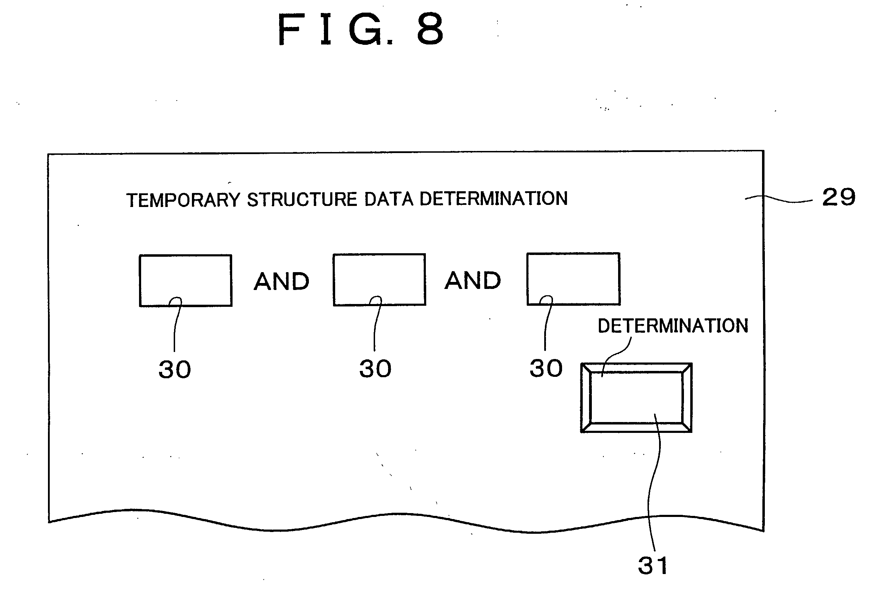

Fig. 8 shows a determination screen 29 displayed on the display of the output device 4 when operating the temporary structure data determination button 28. The determination screen 29 is provided with a plurality of input columns 30 for inputting names including symbols, etc. of the units and a determination button 31 operated when determining the conditions input in the input columns 30. The total number of the input columns 30 is not limited to three as shown in Fig. 8 and may be varied in accordance with the number of the units.

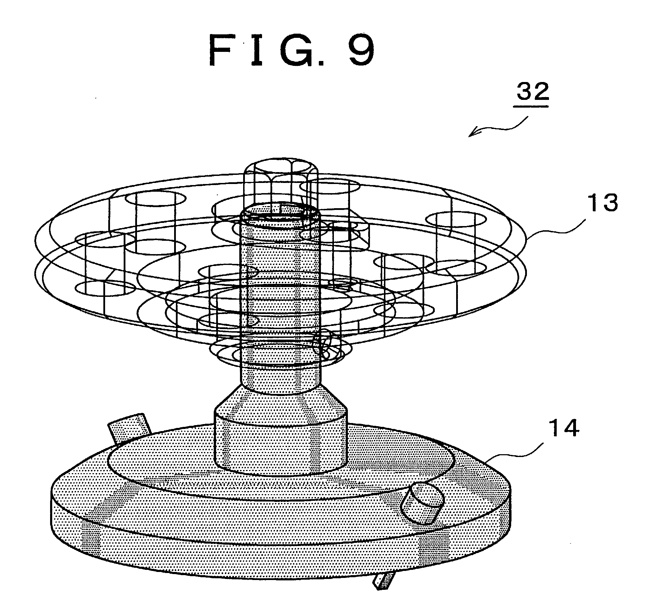

The designer can input the names of the units to be related to each other among the plurality of the units which correspond to the elements of the product 11 in the input columns 30. After entries have been input into the input columns 30, by clicking the determination button 31 with the mouse, the entry conditions input into the input columns 30 are determined as the temporary structure data. In this embodiment, the unit 13 and the unit 14 are related and the unit 15 is unrelated, as shown in Fig 9.

After determining the temporary structure data, the entire portion of the product 11 is again displayed on the display of the output device 4. When the detail button 24 is clicked while selecting the unit 14, the simplified view 32 excluding the unit 15 is displayed as shown in Fig. 9. That is, based on the temporary structure data, the design drawing creation portion 6 omits the unit 15, and creates the simplified view 32 in which the unit 14 is shown in the detail view as solid shadowing and the unit 13 is shown in the outline view. Thus, by isolating unrelated portions from the plurality of the units, the isolated unit is not displayed on the display.

The determination of the temporary structure data is practicable not only being carried out as the transaction before displaying the simplified view, but also after displaying the simplified view 23. For example, when determining the temporary structure data for isolating the unit 15 from the other two units 13, 14 after displaying the simplified view 23 shown in Fig. 6, the simplified view 32 without the unit 15 is displayed as shown in Fig. 9, instead of the simplified view 23 of Fig. 6.

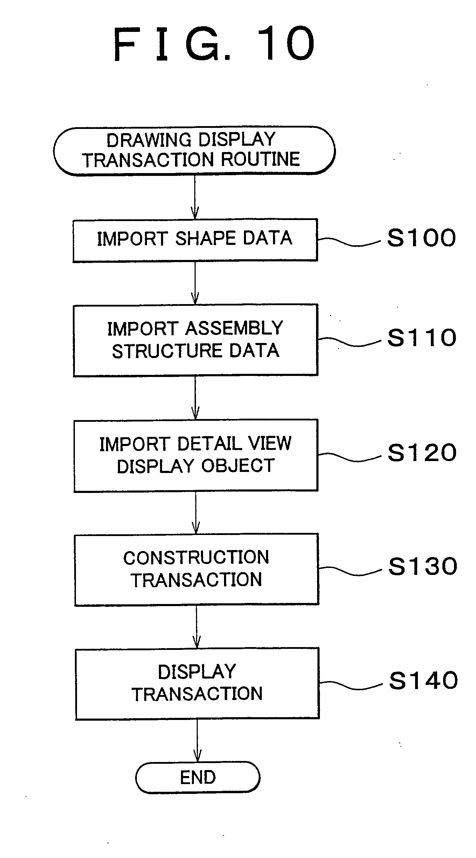

Fig. 10 illustrates the control procedure carried out by the control device 2 following the drawing display program when constructing the simplified view 23.

In step S100, shape data of the selected part is imported. That is, the shape data relating to the part input by a user is imported from the part shape database 9.

In step S110, the assembly structure data is imported. That is, the assembly structure data showing the relation between each part specified by the user is imported from the assembly structure database 10.

In step S120, the detail view display object is imported. That is, the unit selected by the designer to be displayed as the detail view when creating the design drawing is recognized as the detail view among the plurality of the units.

In step S130, the construction procedure of the simplified view 23 is carried out. That is, the simplified view 23 is constructed based on the shape data and the assembly structure data so that the unit selected by the designer is constructed in the detail view and the other units related to the detail view which were not selected are constructed in the outline view.

In step S140, a display procedure to the output device 4 is carried out. That is, the simplified view 23 is displayed on the display of the output device 4 so that the user performs the designing (i.e., construction) operation for the unit displayed in detail.

Accordingly, to this exemplary embodiment, the following effects can be achieved.

According to the embodiment of the present invention, the simplified views 23, 32 are displayed by determining, or generating, the unit selected by the designer as the design object in the detail view, and the other unselected units related to the detail view in the outline view. Thus, when displaying the product 11, the unit to be the object of the design can be easily displayed in the detail view. In addition, because volume of data relating to rendering the unit displayed with the outline is reduced, the entire data volume necessary for displaying the product 11 on the display is reduced. Moreover, the designer can prevent sensitive portions considered as a trade secret from being rendered in the outline view, thereby ensuring secure protection of the product 11.

First, the entire portion of the product 11 is displayed in a detail view. Then the procedure for displaying the selected unit of the product 11 is displayed in the detail view and the other unselected units in the outline view on the display. For simplicity of display to the designer, the product 11 to be displayed is simplified level by level from the higher level by the parting unit. Thus, the designing object of the product 11 can be displayed to be simplified level by level from a rough level, and the check and the confirmation of the design drawing can be easily performed.

According to the exemplary embodiment of the invention, the outline view is constructed without considering clearance, when displaying the outline view of the units which include the clearance between each part in an actual shape because of the measurement for the designing. That is, as shown in Fig. 7, although the actual product includes the clearance between the external periphery of the cylindrical part 25 and the internal periphery of the bore 27 of the block part 26, the diameter R of the cylindrical part 25 is displayed as the same size with the diameter D of the bore 27 when displayed in outline view. Thus, the visible outline showing the external periphery of the cylindrical part 25 and the visible outline showing the internal periphery of the bore 27 of the block part 26 are omitted for displaying the product 11 with the simplified outline view while avoiding unnecessary lines.

According to the exemplary embodiment of the invention, by determining the temporary structure data, the unit of the design object and the other units can be related to each other and isolated from each other. Thus, by isolating the unrelated portions for the design among the plurality of the units constructing the product 11, the unrelated unit is not displayed on the display, and the otherwise unselected units are no longer difficult when constructing the unit to be designed.

The exemplary embodiments of the construction view display device, the construction view display method and the recording media thereof of this invention is not limited to the foregoing embodiment and may be modified as follows.

The drawing data is not limited to be constructed with the shape data and the assembly structure data. That is, the format and content are not limited as long as the data is capable of displaying the product structured with the plurality of the parts in a CAD drawing on the display.

The relating (or relational) information is not limited to the assembly construction data. For example, the relational information may be the assembly condition data, may be determined by the assembly condition data when displaying the simplified view in the outline view. The assembly information may correspond to additional input data for relating a predetermined unit and other units. The existence of a relation may be determined based on the newly added data. In this case, the units having different levels of the assembly structure data can be related each other.

When displaying a portion of the product 11 in the detail view and the other portion in the outline view, it is not limited that the displaying unit is not by the unit. For example, the portion to be displayed in the detail view is dragged using the mouse and by clicking the detail button 25. Under this condition, the selected portion is displayed in the detail drawing, and the other portions are displayed in the outline view.

Although it is mentioned that the detail view includes the solid shadowing according to the embodiment, it is not limited to this form and the condition of the detail view can be rendered to any degree capable of rending a design. Although it is mentioned that the outline view is displayed only with visible outlines, according to the foregoing embodiments, the condition of the outline view is to be simplified to be displayed to the extent that the unit can be recognized.

When displaying the simplified views 23, 32, it is not required that the unit to be displayed as the detail view be specified by the designer. To the contrary, the unit to be displayed in the outline view may be specified.

The procedure for displaying the simplified view is not limited to be performed level by level by the parting unit in accordance with the operation of the designer until only the unit to be the design object of the designer is displayed as the detail view. By displaying the input screen for inputting the unit name (i.e., part name) on the display for inputting the unit after the second level of the parting unit, for example, the parting unit may display the simplified view of the second level without displaying the first level.

As shown in Fig. 7, although the display is controlled by determining the diameter R of the cylindrical part 25 inserted into the bore 27 to be the size of the diameter D of the bore 27 when displaying the outline view of the portion where the cylindrical part 25 is inserted into the bore 27, this procedure may be omitted. The sectional form of the cylindrical part 25 and the bore 27 in radial direction may be any one of a circle, an oval, a polygon, or the like. The assembly object to which the cylindrical part 25 is assembled is not limited to the bore 27 and may be a recess portion having a predetermined depth.

Although the existence of the relation between the unit to be the design object and the other units is determined by inputting the temporary structure data, and the unselected unit relative to the unit of the design object is omitted when displaying the simplified view, this procedure is not fundamental.

The input format of the assembly structure data is not limited to the foregoing exemplary embodiments. For example, when inputting the assembly structure data, the assembling relation data may be input by adding the assembly structure data to the shape data simultaneous with the input of the shape data of the part without inputting the assembling relation data with tree structure as shown in Fig. 3. Likewise, the assembly condition data may be input along with the input of the shape data without opening the input screen 18 as shown in Fig. 4.

The system for constructing the design drawing is not limited to a CAD system. Other systems are applicable as long as the drawing is designed with the aid of a controller, such as a computer.

The recording media is not limited to a CD-ROM 8. Other medium may include, but is not limited to, a floppy (R) disc, memory card or any other memory storage device.

The object of the design drawing is not limited to the product 11 of the foregoing embodiment. The construction view display device 1 can be applied when creating an image of various products, such as automobile parts, electric appliances, machine tools, toys, etc.

The technical scope obtained from the embodiment and other examples and the effects thereof will be explained as follows.

(1) The relating information includes the assembly condition data for showing the assembly condition between parts. The construction device carries out the procedure for constructing the unit or the part determined by the selective information in the detail view and the unit or the part related to the detail view based on the assembly condition data in the outline view for displaying a design drawing thereof on the display device.

(2) The relating (or relational) information includes the assembly structure data for showing the assembling relation of the construction view object hierarchically by the unit or by the part for showing the assembly condition between parts. The construction device carries out the procedure for constructing the unit or the part determined by the selective information in the detail view, and the unit or the other parts also related to the detail view based on the assembly structure data in the outline view for displaying a design drawing thereof on the display device.

(3) The relational information includes the temporary structure data for determining the existence of the relation between the units and the parts. The construction device carries out the procedure for constructing the unit or the part determined by the selective information in the detail view, for constructing the unit or the other parts related to the detail view based on the temporary structure data in the outline view. And, for omitting the unit or the part unselected and/or unrelated to the detail view based on the temporary structure data to display a design drawing thereof on the display device.

(4) The construction device carries out the procedure for constructing the unit or the part determined by the information in the detail view and the unit or the part related to the detail view based on the relating information in the outline view from the higher level by level of the assembling relation data showing the assembling relation of the construction view object hierarchically by the unit or by the part.

(5) The construction device carries out the procedure for constructing the outline view by simplifying the drawing by, e.g., determining the diameter of a part assembled to a bore or a recess portion to a diameter of the part or the recess portion when constructing the outline view of the part assembled to the bore or the recess portion of the design drawing.

(6) The recording media is readable by the computer and recorded with the program for carrying out each step by the computer.

According to the exemplary embodiment of the invention, because the unit or the part selected by the operator or designer is displayed in the detail view, and because the unit or the unselected part related to the detail view is displayed in the outline view automatically among the design drawings regarding the construction view object, the drawing which is the construction object of the operator can be easily processed and displayed in the detail view.

While the invention has been described with reference to exemplary embodiments thereof, it is to be understood that the invention is not limited to the exemplary embodiments or constructions. To the contrary, the invention is intended to cover various modifications and equivalent arrangements. In addition, while the various elements of the exemplary embodiments are shown in various combinations and configurations, which are exemplary, other combinations and configurations, including more, less or only a single element, are also within the spirit and scope of the invention.

**Claims**

1. A display system that constructs a drawing of an object on a display device with an aid of a computer, comprising:

    a memory (9, 10) that stores drawing data of at least one part of the object;
    an input device (3) that receives input conditions used to display the drawing on a display screen of the display device (4); and
    a controller (2) that:

        imports selective information input from the input device (3) to determine the at least one part of the object selected to be displayed in at least one of a detail view (14) and an outline view (13, 15);
        imports relational information input using the input device (3) to determine a relation between parts;
        reads-in the drawing data from the memory (9, 10); and
        constructs the at least one part of the object selected in at least one of the detail view (14) and the outline view (13, 15) on the display device (4) based on the imported relational information.

2. A display system according to claim 1, **characterized in that** the relational information comprises:

    assembly condition data that shows an assembling condition between the parts of the object, and
    that the controller (2) constructs the at least one part of the object selected in the detail view (14) and at least one part unselected, and related to the detail view (14), in the outline view (13, 15) on the display device (4) based on the assembly condition data.

3. A display system according to claim 1 or 2, **characterized in that** the relational information comprises:

    assembly structure data that shows an assembling relation of at least one part of the object by sub-portions of the parts to show the assembling condition between the at least one part; and
    that the controller (2) constructs the object determined by the at least one part selected in the detail view (4) and the at least one part unselected, and related to the detail view (4), in the outline view (13, 15) on the display device (4) based on the assembly structure data.

4. A display system according to any one of claims 1 through 3, **characterized in that** the relational information comprises:

    temporary structure data that determines an existence of a relation between the parts, and that the controller (2):

        constructs the at least one part selected in the detail view (14);
        constructs the at least one part unselected, and related to the detail view (14), in the outline view (13) based on the temporary structure data; and
        omits at least one part unselected, and unrelated to the detail view (14), from being displayed on the display device (4) based on the temporary structure data.

5. A display system according to any one of claims 1 through 4, **characterized in that** the controller (2) constructs:

    the at least one part selected in the detail view (14); and
    the at least one part unselected, and related to the detail view (14), in the outline view (13) on the display device (4) based on the relational information,

    and **characterized in that** each part of the object is made up of numerous portions parsed into various levels and the controller (2) constructs the drawing of the object, level by level, based on assembling relation data.

6. A display system according to any one of claims 1 through 5, **characterized in that** the controller (2) constructs the outline view of the object by reducing unnecessary lines in an outer shape of at least a first part (25) that is matingly assembled to a second part (26) when constructing the outline view.

7. A display method that constructs a drawing of an object with an aid of a computer on a display device (4), comprising the steps of:

    importing (5) selective information input from an input device (3) when selecting a portion of the object to be displayed in at least one of a detail view (14) and an outline view (13, 15);
    importing relational information input using the input device (3) to determine the relation between the parts;
    reading-in stored drawing data;
    constructing at least one part of the object selected in a detail view (14); and

constructing at least one part of the object unselected, and related to the detail view, in an outline view (13, 15) on the display device (4) based on the relating information.

**8.** A display method according to claim 7, wherein the relational information comprises assembly condition data that shows an assembly condition between the parts, the method further comprising the steps of:

constructing the at least one part selected in the detail view (14); and

constructing the at least one part unselected, and related to the detail view (14), in an outline view (13, 15) on the display device (4) based on the assembly condition data.

**9.** A display method according to claim 7 or 8, wherein the relational information comprises assembly condition data that shows an assembling relation of the parts of the object by levels, further comprising the steps of:

constructing the at least one part selected in the detail view (14); and

constructing the at least one part unselected, and related to the detail view (14), in the outline view (13, 15) on the display device (4) based on the assembly structure data.

**10.** A display method according to any one of claims 7 through 9, wherein the relational information comprises temporary structure data that determines an existence of a relation between the parts, further comprising the steps of:

constructing the at least one part selected in the detail view (14);

constructing the at least one part unselected, and related to the detail view (14), in the outline view (13); and

omitting at least one part unselected, and unrelated to the detail view (14), from being displayed on the display device (4) based on the temporary structure data.

**11.** A display method according to any one of claims 7 through 10, **characterized in that** the constructing the at least one part selected, and the at least one part unselected, and related to the detail view (14), based on the relational information, is constructed level by level based on an assembling relation data hierarchically.

**12.** A display method according to any one of claims 7 through 11, **characterized by** further comprising the step of:

constructing the outline view of the object by reducing unnecessary lines in an outer shape of at least a first part (25) that is matingly assembled to a second part (26) when constructing the outline view.

**13.** A recording media readable by a computer, wherein a program is recorded on the recording media for carrying out each step of the display method according to claim 7 by a computer.

# F I G. 1

ASSEMBLY STRUCTURE DATABASE 10

PART SHAPE DATABASE 9

1

5 CONSTRUCTION CONTENTS DETERMINATION PORTION

6 DESIGN DRAWING CREATION PORTION

2

8

READ-IN DEVICE 7

INPUT DEVICE 3

OUTPUT DEVICE 4

EP 1 304 657 A2

# FIG. 2

DETAIL — 24

TEMPORARY STRUCTURE DATA DETERMINATION — 28

11

13

14

15

12

EP 1 304 657 A2

# F I G. 3

```
PRODUCT 11 ── UNIT 13 ── UNIT ── UNIT ── PART ┐
                                          PART ┘ 17
                              ── UNIT ── PART ─ 17
                        ── UNIT ── UNIT ── PART ─ 17
                              ── UNIT ── PART ┐
              UNIT 14 ── UNIT ── UNIT ── PART ┘
                              ── UNIT ── PART ─ 17
                        ── UNIT ── UNIT ── PART ┐
                              ── UNIT ── PART ┘ 17
              UNIT 15 ── UNIT ── UNIT ── PART ┐
                              ── UNIT ── PART ┘ 17
                        ── UNIT ── UNIT ── PART ┐
                              ── UNIT ── PART ┘ 17
```

16

FIRST LEVEL    SECOND LEVEL    THIRD LEVEL ... PART LEVEL

# F I G. 4

PART ◯ ◯

ASSEMBLING
POSITION
[_____]⟶19

ASSEMBLING
DIRECTION

$I_X$ [ ]   $I_Y$ [ ]   $I_Z$ [ ]

20     20     20

18

EP 1 304 657 A2

# FIG. 5

ASSEMBLING POINT S

21

$(I_X, I_Y, I_Z)$

ASSEMBLING POINT T

22

Z

X

Y

EP 1 304 657 A2

# FIG. 6

EP 1 304 657 A2

# FIG. 7

EP 1 304 657 A2

# FIG. 8

EP 1 304 657 A2

# F I G. 9

32

13

14

EP 1 304 657 A2

# F I G. 10

```
   ┌─────────────────────────┐
   │    DRAWING DISPLAY      │
   │  TRANSACTION ROUTINE    │
   └─────────────────────────┘
               │
               ▼
   ┌─────────────────────────┐
   │   IMPORT SHAPE DATA     │──── S100
   └─────────────────────────┘
               │
               ▼
   ┌─────────────────────────┐
   │   IMPORT ASSEMBLY       │──── S110
   │   STRUCTURE DATA        │
   └─────────────────────────┘
               │
               ▼
   ┌─────────────────────────┐
   │  IMPORT DETAIL VIEW     │──── S120
   │  DISPLAY OBJECT         │
   └─────────────────────────┘
               │
               ▼
   ┌─────────────────────────┐
   │    CONSTRUCTION         │──── S130
   │    TRANSACTION          │
   └─────────────────────────┘
               │
               ▼
   ┌─────────────────────────┐
   │    DISPLAY              │──── S140
   │    TRANSACTION          │
   └─────────────────────────┘
               │
               ▼
         ┌───────────┐
         │    END    │
         └───────────┘
```